# EUROPEAN PATENT APPLICATION

(11) **EP 4 770 314 A1**
(43) Date of publication of application: **01.07.2026**
(21) Application number: 25212589.3
(22) Date of filing: 31.10.2025
(51) Int. Cl.: H10D 8/00, H10D 8/01, H10D 62/10, H10D 30/00, H10D 84/80

(54) **PROTECTIVE DIODE LINER FOR BACKSIDE PROCESSING**

(30) Priority: 27.12.2024 US 202419003601
(71) Applicant: Intel Corporation, Santa Clara, CA 95054 (US)
(72) Inventor: Mariottini, Giorgio, Sandy UT, 84094 (US); Harris, Daniel, Beaverton OR, 97006 (US); Mandal, Saptarshi, Beaverton OR, 97008 (US); Puls, Conor, Portland OR, 97229 (US); Tasneem, Nujhat, Atlante GA, 30329 (US); Gao, Weihong, Portland OR, 97229 (US); Shah, Amish, Portland OR, 97229 (US); Pell, Christopher J., Hillsboro OR, 97124 (US); Lahiri, Jurick, Beaverton OR, 97005 (US); Sengezer, Engin Cem, Hillsboro OR, 97124 (US); Reimao, Daniel Mansur, Portland OR, 97229 (US); Hsieh, Tien-Lin, Beaverton OR, 97007 (US); Kallick, Jeremy D., Portland OR, 97205 (US); Sarkar, Sayan, Cornelius OR, 97113 (US); Wilt, Jamie S., Tualatin OR, 97062 (US); Kioussis, Dimitri, San Jose CA, 95118 (US); Davidson, Forrest, Portland OR, 97227 (US)
(74) Representative: Samson & Partner Patentanwälte mbB

(57) **Abstract**

Semiconductor devices and systems with a protective diode cap, and methods of forming the same, are disclosed herein. In one example, a semiconductor device includes a fin, p-type and n-type epitaxial structures over the fin, and a dielectric liner under the fin, where the dielectric layer does not include oxygen.

## Description

### BACKGROUND

Backside power delivery is a technology for semiconductor chips where electrical power is supplied to the active circuitry from the backside of a chip rather than the frontside. A chip with backside power delivery typically includes backside and frontside interconnects, along with electrical connections between the backside and frontside for power delivery and signaling to/from the active circuitry. During fabrication of chips with backside power delivery, however, diodes may be exposed to contaminants, which can reduce diode performance and lead to lower yield.

### BRIEF DESCRIPTION OF THE DRAWINGS

**FIGS. 1A-B** illustrate cross-section views of a semiconductor device with a protective diode liner.
**FIGS. 2A-B** illustrate example implementations of a diode with a protective subfin liner.
**FIGS. 3A-H** illustrate a process flow for forming a semiconductor device with protective diode liners.
**FIG. 4** illustrates a graph showing the ideality of diodes with and without a protective silicon nitride liner.
**FIG. 5** illustrates a graph showing the variability in ideality for diodes with and without a protective silicon nitride liner.
**FIG. 6** illustrates a graph showing the ideality of diodes protected with a nitride liner versus an oxide liner.
**FIG. 7** illustrates a cross-section view of an integrated circuit that may include protective diode caps.
**FIG. 8** illustrates a flowchart for forming an integrated circuit that may include protective diode caps.
**FIG. 9** illustrates a top view of a wafer and dies that may be included in a microelectronic assembly.
**FIG. 10** illustrates a cross-sectional side view of an integrated circuit device that may be included in a microelectronic assembly.
**FIGS. 11A-D** illustrate perspective views of example planar, FinFET, gate-all-around, and stacked gate-all-around transistors.
**FIG. 12** illustrates a cross-sectional side view of an integrated circuit device assembly that may include a microelectronic assembly.
**FIG. 13** illustrates a block diagram of an example electrical device that may include a microelectronic assembly.

### DETAILED DESCRIPTION

Backside power delivery is a technology for semiconductor chips where electrical power is supplied to the active circuitry from the backside of a chip rather than the frontside. A chip with backside power delivery typically includes backside and frontside interconnects, along with electrical connections between the backside and frontside for power delivery and signaling to/from the active circuitry.

During fabrication of chips with backside power delivery, however, diodes may be exposed to contaminants, which can reduce diode performance and lead to lower yield. For example, the subfin silicon used to form the P-N junction of a diode may be exposed to contaminants during backside processing, such as re-sputtered metal from conductive layers (e.g., deep vias, backside contacts, backside metal layers, etc.). As a result, the subfin becomes contaminated by metal, which increases the ideality factor of the diode and reduces its performance.

Accordingly, this disclosure presents embodiments of diodes with a protective subfin liner for protection from contaminates during backside processing, along with devices and systems incorporating the same, and methods of formation. For example, when the subfins are first revealed during backside processing (e.g., after polishing/removing the substrate), cleaning treatments may be used to remove any contaminants from the subfins, and a protective liner or cap may be formed over the subfins after recess with a selective etch or polish. In this manner, during subsequent processing, the protective liner protects the diode subfins from contaminants, such as re-sputtered metal during transistor processing (e.g., subfin removal, deep via reveal, backside contact formation) and during backside interconnect processing (e.g., backside metal layer formation). The material composition and thickness of the film used to form the protective liner may be tuned to meet diode ideality performance targets and other process-specific requirements, such as dry etch requirements for subfin removal, polish requirements for dielectric fill to reveal electrical connections (e.g., deep vias, backside contacts), etc.

The described embodiments may provide various advantages, including lower diode ideality, better diode performance, and higher yield. For example, the protective liner protects the diode subfin from contaminants, which helps achieve low diode ideality, thus improving performance. In this manner, diode performance targets can be met for backside power delivery architectures. Moreover, the protective diode liner may reduce die kill rates resulting from diode errors, such as degraded diode performance at high temperatures, by a factor of 5x in some cases, which increases yield.

The described embodiments also enable the use of lower resistance metals in conductive layers (e.g., vias, conductive contacts), which provide better electrical performance but are often avoided because they are also potent contaminates that can degrade diode performance more than other metals. For example, because the protective diode liner reduces the risk of contamination, low resistance metals like molybdenum (Mo), which are normally a potent source of contamination, can be used instead of other metals like tungsten (W), thus improving electrical performance.

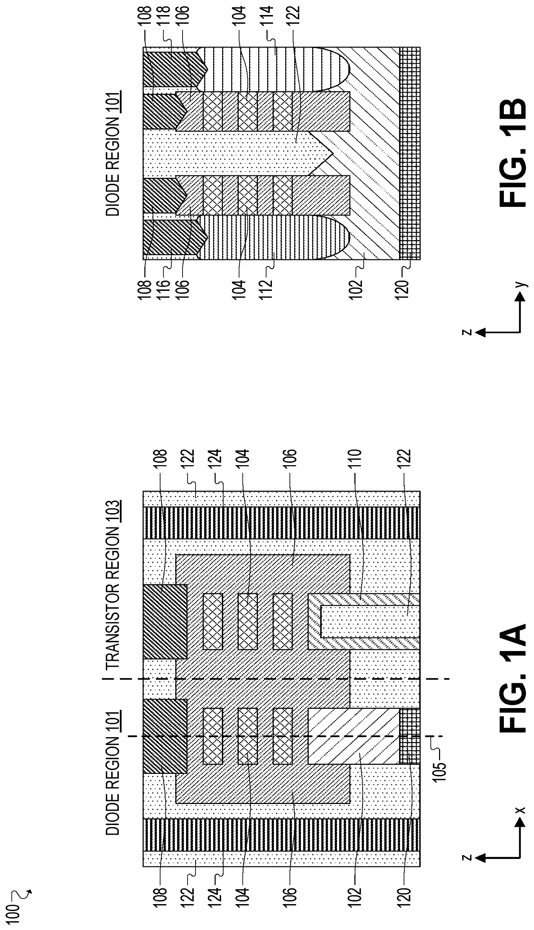

**FIGS. 1A-B** illustrate cross-section views of an example semiconductor device 100 with a protective diode liner 120. In the illustrated example, FIG. 1A shows a cross-section view of semiconductor device 100 along an x-z plane, and FIG. 1B shows a cross-section view of the diode region 101 along a y-z plane (based on the cut line 105 shown in FIG. 1A).

In the illustrated embodiment, the semiconductor device 100 includes a diode region 101 and a transistor region 103, where the diode region 101 includes various structures that collectively form one or more diodes, and the transistor region 103 includes various structures that collectively form one or more transistors. In FIG. 1A, the diode and transistor regions 101, 103 are shown side by side for simplicity, but in actual embodiments, the diode region 101 and the transistor region 103 may be in different areas of the semiconductor device 100.

The diode region 101 includes a vertical semiconductor (e.g., silicon) "subfin" 102 with a protective liner 120 (e.g., on the bottom or backside of the subfin 102), horizontal channel fins 104 (e.g., nanowires, nanoribbons, or nanosheets) above the subfin, a gate 106 surrounding the channel fins 104, a gate contact 108, and a deep via 124 extending vertically through the diode region 101, as shown in FIG. 1A. The diode region 101 also includes a p-type epitaxial structure 112 and an n-type epitaxial structure 114, along with an anode 116 and a cathode 118 on the p-type epitaxial structure 112 and the n-type epitaxial structure 114, respectively, as shown in FIG. 1B. In the illustrated embodiment, certain layers in the diode region 101 may be non-functional layers formed as a result of the transistor processing (e.g., the channel fins 104, gate 106, gate contact 108, etc.).

The transistor region 103 similarly includes channel fins 104 (e.g., nanowires, nanoribbons, or nanosheets), a gate 106 surrounding the channel fins 104, a gate contact 108, and a deep via 124 extending vertically through the transistor region 103, as shown in FIG. 1A. The transistor region 103 may also include other layers not visible in the view shown in FIG. 1A, such as epitaxial source/drain structures, conductive source/drain contacts, etc.

In the transistor region 103, however, the subfin 102 has been removed and replaced with a subfin gate liner 110 and dielectric fill 122 to prevent leakage through the subfin 102. For example, in architectures where gate-all-around (GAA) transistors 103 are integrated with backside power delivery, the remaining subfin 102 in the transistor region 103 creates a parasitic leakage path, which impacts the effective capacitance of the transistors 103. As a result, the subfin 102 is etched out of the transistor region 103 to eliminate the leakage path.

In the diode region 101, however, the silicon subfin 102 needs to be preserved, as it is used to create the P-N junction in the diodes 101. As a result, when the subfin 102 is removed from the transistor region 103, the diode region 101 is masked or covered to preserve the subfin 102 for the diode structures 101. During this process flow, however, the surface of the diode subfin 102 is exposed to contaminants, which affects carrier recombination in the junction and reduces the final diode ideality performance. As a result, in the illustrated embodiment, the diode subfin 102 includes a protective hermetic liner 120 to protect the subfin 102 from contamination during processing. In this manner, good diode ideality performance is achieved for the resulting diodes 101.

The remaining area in semiconductor device 100 is filled with one or more inter-layer dielectrics (ILDs) 122.

The protective cap 120 may include any suitable hermetic material, including nitrides and carbides, such as silicon nitride (SiN) or silicon carbide (SiC). Thus, in some embodiments, the protective cap 120 may include elements such as (i) nitrogen, (ii) silicon and nitrogen, (iii) carbon, or (iv) silicon and carbon. In other embodiments, the protective cap 120 may include oxides.

The subfin 102 may include any suitable semiconductor, such as silicon.

The p-type epitaxial structure 112 may include any suitable p-type semiconductor, such as boron-doped silicon or boron-doped silicon germanium. Thus, in some embodiments, the p-type epitaxial structure 112 may include elements such as (i) silicon and boron, or (ii) silicon, germanium, and boron.

The n-type epitaxial structure 114 may include any suitable n-type semiconductor, such as phosphorus-doped silicon or arsenic-doped silicon. Thus, in some embodiments, the n-type epitaxial structure 114 may include elements such as (i) silicon and phosphorus, or (ii) silicon and arsenic.

The channel fins 104 may include any suitable semiconductor material, including group IV semiconductors (e.g., silicon (Si), germanium (Ge), silicon germanium (SiGe), etc.) and group III-V semiconductors (e.g., gallium nitride (GaN), gallium arsenide (GaAs), indium phosphide (InP), etc.).

The gates 106 may be made of any suitable conductive (e.g., metal) material.

The anodes 116, cathodes 118, and gate contacts 108 may be made of any suitable conductive (e.g., metal) material.

The diode subfin 102 may also be referred to herein as a diode fin 102, as the diode subfin 102 may be a vertical fin structure below the horizontal channel fin structures 104.

The protective liner 120 may also be referred to as a protective cap or layer, a hermetic liner, cap, or layer, a dielectric liner, cap, or layer, etc.

It should be appreciated that semiconductor device 100 is merely an example embodiment and numerous other embodiments are also within the scope of this disclosure. In various embodiments, for example, certain elements of semiconductor device 100 may be modified, replaced, rearranged, omitted, and/or added. For example, the semiconductor device 100 may include any number of diodes and transistors in the diode region 101 and transition region 103, respectively. The diode region 101 may include any number of subfins 102, p-type and n-type epitaxial structures 112, 114, anodes 116 and cathodes 118, channel fins 104, gates 106, gate contacts 108, deep vias 124, etc. The same may be true for the transistor region 103. Moreover, the materials used in each layer may differ from those described above. Further, while transistors in the transistor region 103 are implemented with a gate-all-around (GAA) ribbon field-effect transistor (FET) design, other transistor designs may be used in other embodiments (e.g., FinFET, planar FET, bi-gate transistors, tri-gate transistors).

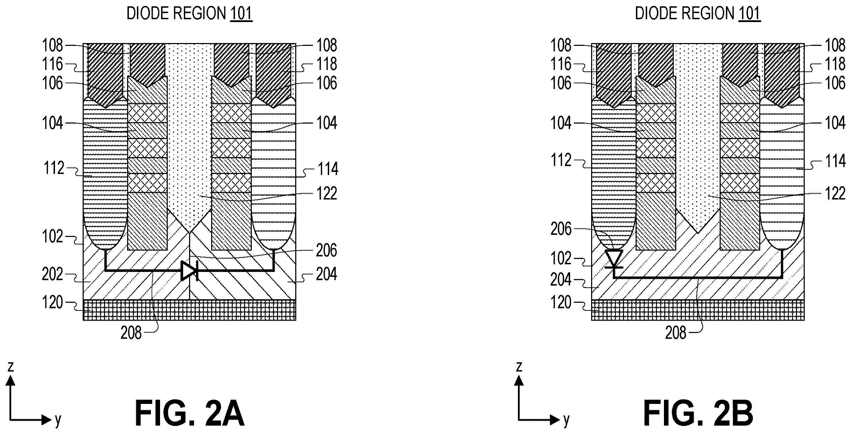

**FIGS. 2A-B** illustrate examples of the implementation and operation of a diode 101 with a protective subfin liner 120. For example, in FIG. 2A, the subfin 102 includes a p-type region 202 under the p-type epitaxial structure 112, and an n-type region 204 under the n-type epitaxial structure 114, thus forming a P-N junction 206 in the middle of the fin 102 at the interface between the p-type region 202 and the n-type region 204. When the P-N junction 206 is formed, electrons from the n-type region 204 diffuse into the p-type region 202 and recombine with holes, which creates a depletion region (e.g., a region near the junction 206 depleted of free carriers) that acts as a barrier to current flow. As a result, current only flows through the diode structure 101 in one direction, along the path 208 from the p-type epitaxial structure 112 to the n-type epitaxial structure 114.

In FIG. 2B, the subfin 102 includes an n-type region 204 under the p-type and n-type epitaxial structures 112, 114, thus forming a P-N junction 206 at the interface between the p-type epitaxial structure 112 and the n-type subfin region 204. As a result, current flows through the diode structure 101 in one direction, along the path 208 from the p-type epitaxial structure 112 to the n-type epitaxial structure 114. In other embodiments, the subfin 102 may include a p-type region 202 (not shown) under the p-type and n-type epitaxial structures 112, 114 (e.g., instead of an n-type region 204), thus forming a P-N junction 206 at the interface between the n-type epitaxial structure 114 and the p-type subfin region 202.

In some embodiments, the p-type region 202 of the subfin 102 may include any suitable p-type dopants in the subfin 102 semiconductor material, such as boron. In some embodiments, the n-type region 204 of the subfin 102 may include any suitable n-type dopants in the subfin 102 semiconductor material, such as phosphorus or arsenic.

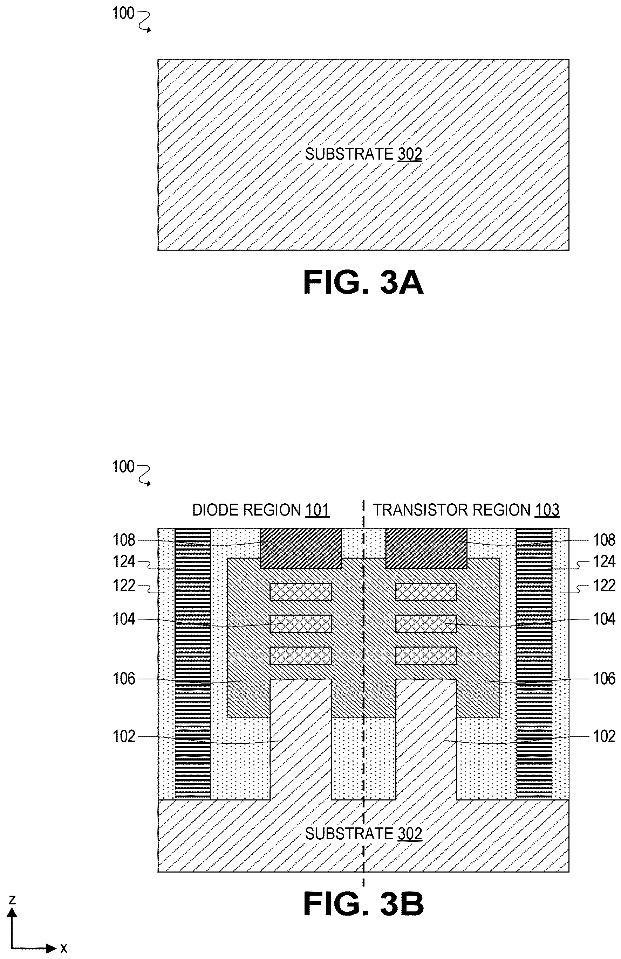

**FIGS. 3A-H** illustrate an example process flow for forming a semiconductor device 100 with protective diode liners. In the illustrated example, FIGS. 3A-H show cross-section (x-z plane) views after performing various steps of the process flow. It will be appreciated in light of the present disclosure that the illustrated process flow is only one example methodology for arriving at a semiconductor device with protective diode caps.

In FIG. 3A, a substrate 302 is received. In some embodiments, the substrate 302 may include silicon (e.g., a silicon wafer).

In FIG. 3B, frontside processing is performed to form a region of diodes 101 and a region of transistors 103 over the substrate 302. The regions of diodes 101 and transistors 103 may be collectively referred to as the device layer.

In the illustrated embodiment, for example, the substrate 302 is patterned into vertical fins 102, and nanowires 104, gates 106, and gate contacts 108 are formed over the fins 102. The vertical fins 102 are also referred to as "subfins," as they are below the horizontal nanowire fins 104.

Other layers not shown in the illustrated view may also be formed in the diode 101 and transistor 103 regions. For example, the diode region 101 may include p-type and n-type epitaxial structures 112, 114, conductive contacts 116, 118 (e.g., anodes/cathodes), etc. Moreover, the transistor region 101 may include source/drain epitaxial structures, conductive contacts (e.g., source/drain contacts), etc.

In the illustrated embodiment, deep vias 124 are also formed through the regions of diodes 101 and transistors 103 (e.g., lateral or adjacent to the diodes 101 and transistors 103) to enable frontside to backside connections. In other embodiments, other approaches may be used for frontside to backside connections, such as backside contacts for diodes 101 and transistors 103.

The remaining areas are filled with one or more inter-layer dielectrics (ILDs) 122.

At this point, the remaining frontside processing may also be performed (not shown), such as forming frontside metal layers that collectively form the frontside interconnect (e.g., primarily for signaling), inter-layer dielectric (ILD) filling and planarization, etc. These processing steps are omitted for simplicity.

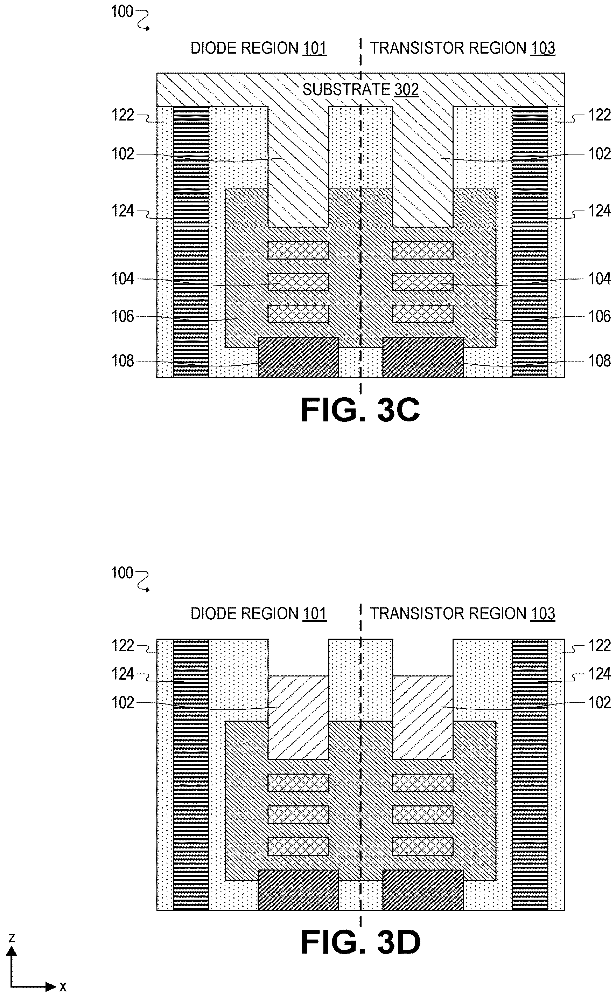

In FIG. 3C, the substrate stack 100 is flipped over to perform backside processing (e.g., with the frontside face down and the backside face up). In some embodiments, before flipping the stack 100 over, a carrier substrate (not shown) may be bonded to the top of the stack 100 for structural support, such that the carrier substrate is at the bottom of the stack 100 after flipping it over. After flipping the stack 100 over, the backside of the original substrate 302 is thinned (e.g., by grinding).

In FIG. 3D, the remaining substrate 302 is removed to expose the deep vias 124, and the subfins 102 are recessed (e.g., below the deep vias 124).

In some embodiments, for example, the substrate 302 may be polished or grinded away from the backside until reaching the dielectric fill 122 (also referred to as "goop") formed during frontside processing, thus removing the substrate 302 and exposing the subfins 102 and deep vias 124 in the dielectric fill 122.

Moreover, after the reveal, the subfins 102 may be recessed below the surface on the backside-and below the top of the deep vias 124-using any suitable technique. For example, in embodiments where polishing is used to remove the substrate 302, the chemical nature of the polish may create a recess in the subfins 102. Alternatively, the subfins 102 may be recessed using etching techniques. For example, specific masks in a photolithography/etch loop, or blanket etches (e.g., dry etch, vapor etch, wet clean), may be used to recess the silicon in the subfins 102.

The topography of the recessed subfins 102 may vary depending on the techniques used to perform the recess. For example, chemical polishing may result in a convex topography on the recessed subfins 102, while etching may result in a fixed (e.g., flat) topography on the recessed subfins 102.

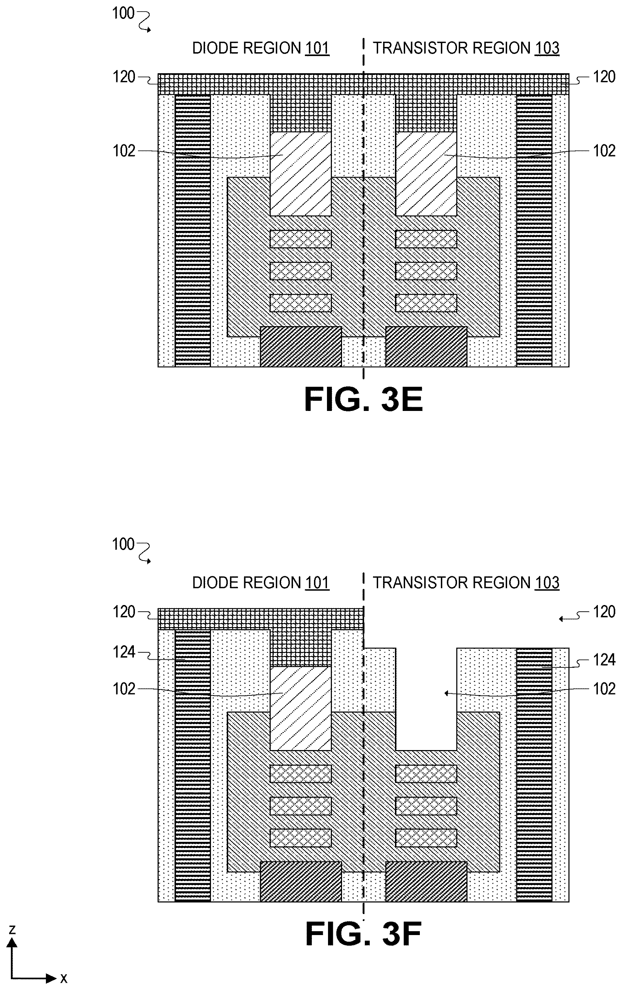

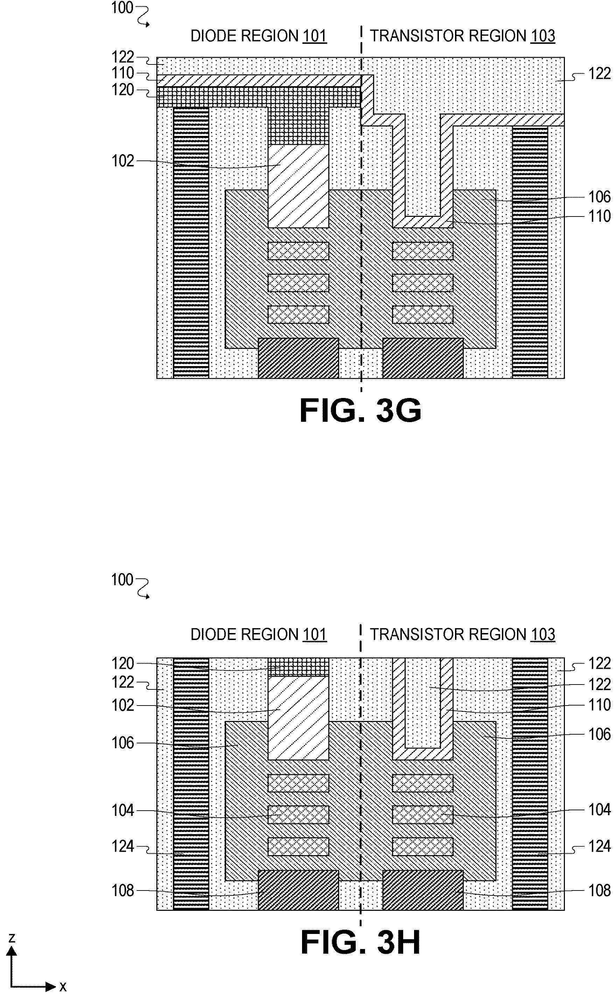

In this manner, the subfins 102 are recessed below the deep vias 124, which enables a protective film 120 to subsequently be deposited over the recessed subfins 102 for protection from contaminants (e.g., in FIG. 3E), while allowing some of the protective film 120 to subsequently be removed to reveal the deep vias 124 (e.g., in FIG. 3H). Regardless of the technique used to recess the subfins 102, the average depth of the recess should be tuned to allow the subsequent polish in FIG. 3H to reveal the deep vias 124 without removing all of the protective film 120 deposited over the recessed subfins 102 in FIG. 3E, thus ensuring that the subfins 102 remain protected.

In FIG. 3E, the surface is first cleaned (e.g., using a wet clean) to remove potential contaminants, and a protective thin film 120 is then deposited to fill the area above the recessed subfins 102. In this manner, a protective liner 120, or cap, is formed over the subfins 102, which protects the diode subfins 102 from contaminants during subsequent processing.

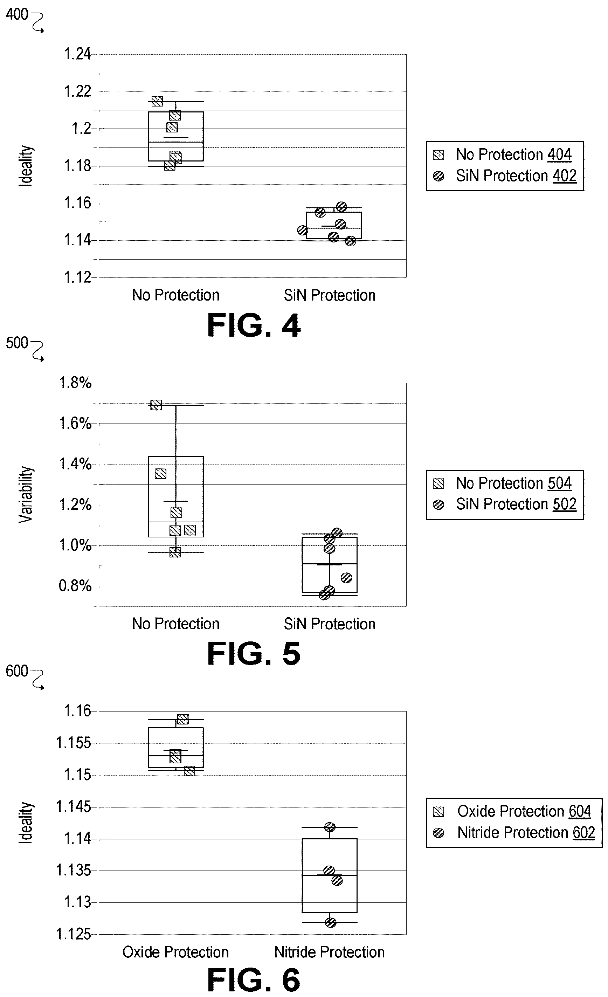

In various embodiments, any dielectric and/or hermetic material may be used to form the protective liner 120. In some embodiments, however, nitrides may be preferable, as they may provide superior protection compared to other materials. For example, when used as a protective liner 120 over the diode subfins 102, nitrides may result in better diode ideality performance than oxides, as described further in connection with FIG. 6.

Thus, in some embodiments, the protective liner 120 may not include an oxide (and may not include oxygen). Rather, in some embodiments, the protective liner 120 may include a nitride, such as silicon nitride (SiN). Alternatively, the protective liner 120 may include any other suitable hermetic material, including a carbide, such as silicon carbide (SiC). In other embodiments, however, the protective liner 120 may include an oxide, such as aluminum oxide (AlOₓ) or silicon oxycarbide (SiOC). Further, in other embodiments, other or more specific materials may be used to form the protective liner 120.

In some embodiments, the nature of the film and the deposition conditions may be tuned for the protective liner 120 (e.g., material composition, thickness, stress, other properties) based on feedback from electrical tests. In some embodiments, the protective liner 120 may preferably have a uniform, conformal thickness or depth. In some embodiments, the thickness of the protective liner 120 may depend on various factors, including, without limitation: (i) the dry etch requirements in FIG. 3F (e.g., the depth of the etch to expose the deep vias 124 in the transistor region 103), (ii) ensuring enough hermiticity is provided to protect against metal contamination during the etch in FIG. 3F, and (iii) ensuring enough of the protective film 120 remains over the diode subfin 102 after the polish in FIG. 3H.

In FIG. 3F, lithographic patterning is used to open the transistor region 103 and mask off the diode region 101. In this manner, the protective liner 120 and subfin 102 can be removed (e.g., etched away) in the transistor region 103 but preserved in the diode region 101.

In some embodiments, for example, a lithography-etch loop may be used to mask off or cover structures in the diode region 101, while leaving the transistor region 103 open. In the open transistor region 103, a dry etch may be used to remove the diode protection liner 120 and the subfin 102. In the illustrated embodiment, the dry etch exposes the metal in the deep vias 124 within the transistor region 103, which causes the metal to be re-sputtered onto the surface of the wafer 100, where the metal remains even after removing the photoresist layer/mask via ashing. In embodiments with other types of frontside to backside connections, such as backside contacts on the transistors 103, metal will similarly re-sputter onto the wafer surface during processing. However, the protective diode liner 120 formed prior to this step (e.g., in FIG. 3E) prevents the metal from touching the surface of the silicon subfins 102 in the diode region 101, thus preventing contamination and preserving diode ideality.

In FIG. 3G, the cavity resulting from removal of the subfin 102 in the transistor region 103 is filled with a subfin gate liner 110 and an ILD layer 122. For example, a hermetic material may be deposited to form a subfin gate liner 110 over the exposed portion of the gate 106 within the subfin cavity, and a dielectric (e.g., an oxide) may be deposited to fill the remaining subfin cavity with an ILD layer 122. In some embodiments, the surface of the wafer 100 may be cleaned before performing these steps to remove contaminants.

During these (and other) transistor processing steps, the protective liner 120 over the subfin 102 in the diode region 101 isolates and protects the subfin 102 from contaminants.

In FIG. 3H, the wafer 100 is polished to planarize the surface and reveal the deep vias 124. Moreover, the diode subfin 102 remains protected from metal contamination when the deep vias 124 are finally revealed, as some of the protective liner 120 still remains over the diode subfin 102 throughout the entire polish. In some embodiments, the resulting protective liner 120 (e.g., post polish) may have a thickness ranging from 5 - 15 nanometers (nm).

At this point, the remaining backside processing may be performed (not shown), such as forming the backside interconnect (e.g., primarily for power delivery), ILD filling and planarization, etc. These processing steps are omitted for simplicity. Throughout the remaining processing, however, the diode subfin 102 remains protected by the protective liner 120, including during formation of backside metal layers (BMₓ) for the backside interconnect (not shown), which is another source of potential metal contamination.

**FIG. 4** illustrates a graph 400 showing the ideality of diodes 402 with a protective silicon nitride (SiN) liner versus diodes 404 without any protection. The "ideality factor" of a diode is a measure of how closely the electrical behavior of the diode matches the behavior of an ideal diode (e.g., the theoretical current-voltage relationship of a diode). An ideality factor having a value of 1 represents an ideal diode, while any value above 1 indicates some loss and inefficiency in the performance of the diode. As shown in graph 400, the diodes 402 with the protective SiN liner have lower ideality than the diodes 404 without any protection, which means the protected diodes 402 perform more like an ideal diode, and thus have better performance, than the unprotected diodes 404.

The improvement in ideality for the protected diodes 402 is due to the protection provided by the SiN liner during backside processing. In particular, the SiN liner prevents the diodes 402 from being contaminated with metal from other structures during processing, such as deep vias (e.g., vias 124), backside contacts, and backside metal layers (BMₓ).

For example, during the subfin 102 removal etch shown in FIG. 3F, metal from the deep vias 124 can be re-sputtered onto the diode subfin 102, causing the subfin 102 to become contaminated with metal, which increases ideality and reduces performance. The problem is exacerbated by the use of lower resistance metals like molybdenum (Mo) as opposed to other metals like tungsten (W) (e.g., in deep vias 124), as contamination from lower resistance metals like molybdenum (Mo) has a greater impact on diode ideality (e.g., higher ideality, lower performance). As a result, while lower resistance metals like molybdenum (Mo) provide better electrical performance, they may be avoided due to the negative impact from contamination.

Similarly, during formation of backside metal layers (BMₓ)-which occurs after the processing shown in FIGS. 3A-H-metal from the backside metal layers, such as aluminum oxide (AlOₓ), can inadvertently contaminate the diode subfin 102.

Trends on electrical diode ideality are correlated with etch times, which demonstrates the need to protect the surface of the subfin 102 before the subfin removal etch. For an etch with higher selectivity and less metal contamination re-sputtering, diode performance (e.g., ideality) improves.

For example, with respect to the protected diodes 402, the protective SiN liner prevents metal contamination in the diode subfin 102 during backside processing (e.g., metal re-sputtering from deep vias, backside metal layers, etc.), which reduces ideality and improves performance. As a result, lower resistance metals such as molybdenum (Mo) may now be used, which may otherwise be avoided due to the impact on diode performance caused by contamination.

**FIG. 5** illustrates a graph 500 showing the variability in ideality for diodes 502 with a protective silicon nitride (SiN) liner versus diodes 504 without any protection. As shown in graph 500, the diodes 502 with the protective SiN liner have less variability in ideality than the diodes 504 without any protection, which translates to more consistent performance and better yield for the protected diodes 502.

**FIG. 6** illustrates a graph 600 showing the ideality of diodes 602 protected with a nitride liner (e.g., silicon nitride (SiN)) versus diodes 604 protected with an oxide liner. As shown in graph 600, the diodes 602 with the protective (hermetic) nitride liner have lower ideality than the diodes 604 with the (non-hermetic) protective oxide liner, which means the nitride-protected diodes 602 perform more like an ideal diode, and thus have better performance, than the oxideprotected diodes 604. Thus, the composition of the film used as the protective liner may impact the level of protection provided to the diode. In particular, nitrides (e.g., SiN) provide superior protection than oxides (e.g., SiO, SiOC, AlOₓ). A nitride liner provides better coverage, and increasing the amount of nitride allows more uniform coverage of the diode.

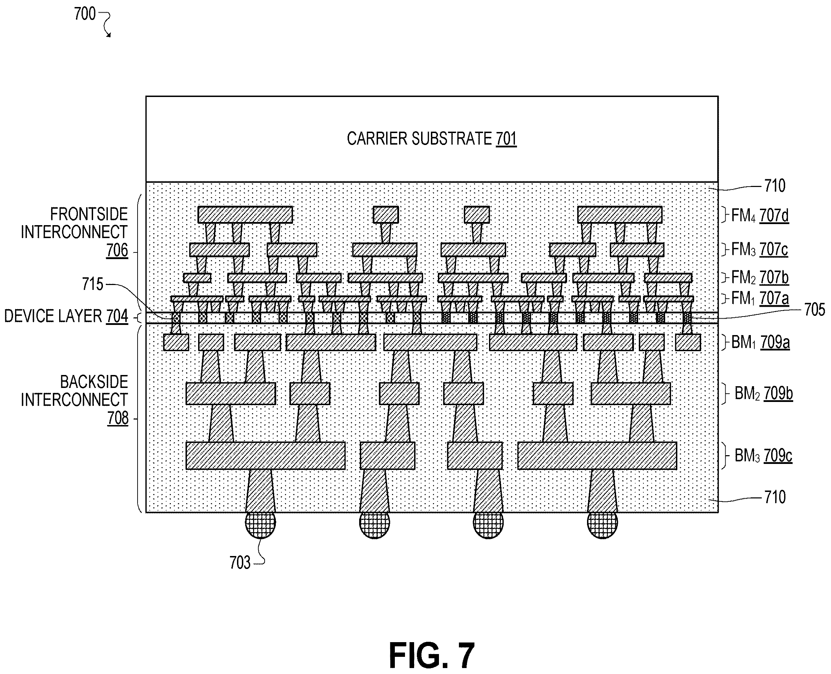

**FIG. 7** illustrates a cross-section view of an integrated circuit (IC) 700 that may include protective diode liners in accordance with certain embodiments. In the illustrated embodiment, for example, IC 700 includes a device layer 704 with diodes 715 and transistors 705. In some embodiments, the diodes 715 may have a protective liner on the backside (e.g., below the diode fin), as described throughout this disclosure.

In the illustrated embodiment, IC 700 includes a device layer 704, a frontside interconnect 706 over the device layer 704, and a backside interconnect 708 under the device layer 704. IC 700 also includes a carrier substrate 701 attached above the frontside interconnect 706 for structural support, along with conductive (e.g., metal) bumps 703 on the bottom surface to electrically couple IC 700 with another electronic device (e.g., an IC package, another IC die/chip, etc.).

In the illustrated embodiment, the original substrate on which the device layer 704 was formed is no longer present in IC 700, or only some residual portions of that substrate remain in IC 700, as all or most of the substate was removed (e.g., grinded or etched away) during fabrication. In other embodiments, however, IC 700 may include some or all of the original substrate below the device layer 704 (e.g., a thinned silicon substrate).

The device layer 704 includes one or more semiconductor devices, such as diodes 715 and transistors 705. Moreover, the diodes 715 may include a protective liner on the backside (e.g., below the diode fin), as described throughout this disclosure. In some embodiments, for example, the diodes 715 may be implemented using the design of diode 101 and may be formed using the process flow of FIGS. 3A-H.

The frontside interconnect 706 includes multiple frontside metal (FM) layers (FM₁₋₄) 707a-d (e.g., primarily for signaling), and the backside interconnect 708 includes multiple backside metal (BM) layers (BM₁₋₃) 709a-c (e.g., primarily for power delivery/ground connections). The remaining areas are filled with one or more inter-layer dielectrics (ILDs) 710.

In the illustrated embodiment, the device layer 704 and interconnects 706, 708 collectively implement logic circuitry with associated power (V_{DD}), ground (Vss), and signal networks (V_{IN}, V_{OUT}). In some embodiments, for example, the logic circuitry may be or may include processing circuitry, memory circuitry, storage circuitry, and/or communication circuitry.

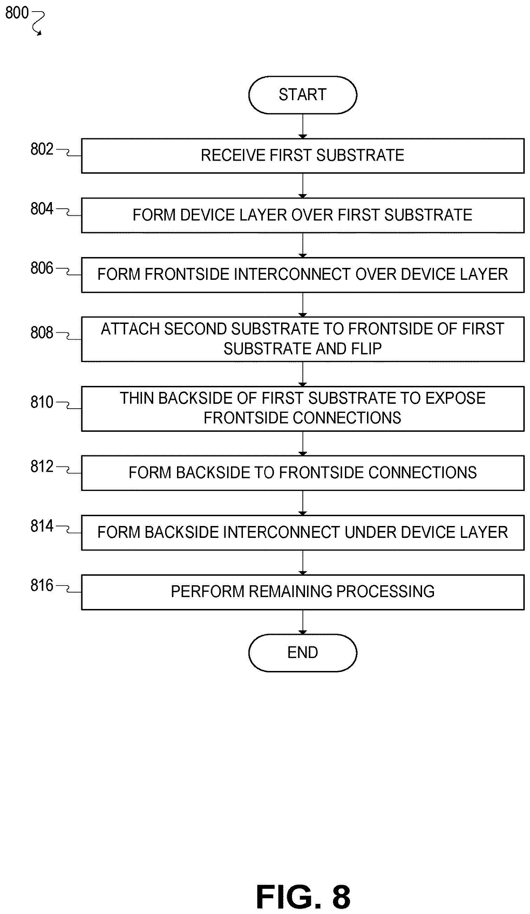

An example process flow for forming IC 700 is described below in connection with FIG. 8.

**FIG. 8** illustrates a flowchart 800 for forming an integrated circuit (IC) that may include protective diode liners in accordance with certain embodiments. It will be appreciated in light of the present disclosure that the illustrated process flow is only one example methodology for arriving at the example IC devices shown and described throughout this disclosure (e.g., IC 700). The steps of the illustrated process flow may be performed using any suitable semiconductor fabrication techniques. For example, film deposition-such as depositing layers, filling portions of layers (e.g., removed portions), and filling via openings-may be performed using any suitable deposition techniques, including, for example, chemical vapor deposition (CVD), metal-organic chemical vapor deposition (MOCVD), molecular beam epitaxy (MBE), atomic layer deposition (ALD), and/or physical vapor deposition (PVD). Moreover, patterning and removal-such as interconnect patterning, forming via openings, and shaping-may be performed using any suitable techniques, such as lithography-based patterning/masking and/or etching.

The illustrated process flow may be used to form one or more IC dies that respectively include a device layer along with frontside and backside interconnects above and below the device layer (e.g., for signaling and power delivery). In some embodiments, the device layer and interconnects may collectively implement logic circuitry and associated signal, power, and ground nets on the respective IC dies. Moreover, at least some of the diodes in the device layer may include a protective backside liner, as described throughout this disclosure.

The flowchart begins at block 802 by receiving a first substrate. In some embodiments, the first substrate may be a wafer or panel and may include silicon (Si).

The flowchart then proceeds to block 804 to form a device layer over the first substrate (e.g., on the frontside). The device layer may include one or more semiconductor devices, such as diodes and/or transistors, to implement the logic circuitry of the respective IC dies. Devices in the device layer may include conductive contacts on the frontside and/or the backside of the device layer, such as source, drain, and gate contacts for transistors, anodes and cathodes for diodes, etc. In some embodiments, at least some of the devices in the device layer may include dummy backside contacts (e.g., to aid in forming the actual backside contacts at block 812). In some embodiments, the device layer may include vias to provide connections between the frontside and the backside of the IC dies.

The flowchart then proceeds to block 806 to form a first interconnect over the device layer (e.g., on the frontside), which may be referred to as the frontside interconnect. For example, multiple conductive (e.g., metal) layers may be formed over the device layer, along with intervening dielectric layers separating the conductive layers. The conductive layers, which may also be referred to as metal layers, may be made of one or more electrically-conductive materials that include one or more metals (e.g., any of the metals/alloys described throughout this disclosure). Further, the dielectric layers may include one or more dielectric materials (e.g., any of the dielectric materials described throughout this disclosure).

Moreover, conductive traces may be patterned (e.g., etched) in the frontside conductive layers, and vias may be formed between the conductive layers (e.g., through the intervening dielectric layers) to electrically couple traces in different conductive layers. The conductive traces and vias patterned in and between the frontside conductive layers may collectively form one or more signal, power, and/or ground nets for the logic circuitry on the respective IC dies (e.g., networks of conductive traces that provide signaling, power, and ground connections).

The signal nets (e.g., V_{IN}, V_{OUT}) may include one or more conductive traces used for signaling (e.g., electrical connections between inputs and outputs of devices/transistors in the device layer), which may also be referred to as signal traces or signal routing. Further, the signal nets in the frontside interconnect may be connected to one or more corresponding signal nets formed in the backside interconnect for off-die signal routing (e.g., as described below with respect to block 814).

The power nets (e.g., V_{DD} or V_{CC}) may include one or more conductive traces for delivering power (e.g., electrical connections between the device layer and one or more power supply terminals), which may also be referred to as power traces or power routing. Further, the power nets in the frontside interconnect may be connected to one or more corresponding power nets formed in the backside interconnect (e.g., as described below with respect to block 814).

The ground nets (e.g., V_{SS}) may include one or more conductive traces for providing ground connections (e.g., electrical connections between the device layer and one or more ground/reference terminals), which may also be referred to as ground traces or ground routing. Further, the ground nets in the frontside interconnect may be connected to one or more corresponding ground nets formed in the backside interconnect (e.g., as described below with respect to block 814).

The flowchart then proceeds to block 808 to attach or bond a second substrate to the frontside of the first substrate (e.g., over the frontside interconnect) and then flip the substrate stack over. The second substrate may be referred to as a carrier substrate (e.g., a silicon carrier wafer or panel).

The flowchart then proceeds to block 810 to thin (e.g., grind) the backside of the first substrate to expose the frontside connection points formed at block 804, such as vias through the device layer, backside contacts in the device layer (e.g., actual contacts or dummy contacts), etc.

In some embodiments, after exposing the frontside connections, diodes in the device layer may be protected with a hermetic liner or cap, as described throughout this disclosure.

The flowchart then proceeds to block 812 to form backside to frontside connections. In some embodiments, for example, backside contacts may be formed on the backside of devices in the device layer. In embodiments with dummy backside contacts, the dummy backside contacts may be etched away and replaced with actual backside contacts.

The flowchart then proceeds to block 814 to form a second interconnect under the device layer (e.g., on the backside), which may be referred to as the backside interconnect.

For example, multiple conductive (e.g., metal) layers may be formed below the device layer, along with intervening dielectric layers separating the conductive layers. The conductive layers, which may also be referred to as backside metal layers, may be made of one or more electrically-conductive materials that include one or more metals (e.g., any of the metals/alloys described throughout this disclosure). Further, the dielectric layers may include one or more dielectric materials (e.g., any of the dielectric materials described throughout this disclosure).

Moreover, conductive traces may be patterned (e.g., etched) in the backside conductive layers, and vias may be formed between the conductive layers (e.g., through the intervening dielectric layers) to electrically couple traces in different conductive layers. The conductive traces and vias patterned in and between the backside conductive layers may collectively form one or more backside power, ground, and/or signal nets for the logic circuitry on the respective IC dies (e.g., networks of conductive traces that provide power, ground, and/or off-chip signal routing connections). For example, the backside power and ground nets may electrically couple the corresponding frontside power and ground nets, and the devices in the device layer, to one or more backside power supply terminals and ground terminals, respectively (e.g., through the vias in the first substrate and device layer). Moreover, the backside signal net may electrically couple the corresponding frontside signal net to one or more off-die or off-chip components (e.g., through the vias in the first substrate and device layer).

In this manner, the backside interconnect is electrically coupled to the frontside interconnect (e.g., through vias and/or devices in the device layer) to provide power delivery and ground connections, along with off-die or off-chip signal routing.

The flowchart then proceeds to block 816 to perform any remaining processing, such as inter-layer dielectric (ILD) filling, planarization, interconnect bump formation, etc. In wafer or panel process flows, the completed wafer or panel may be diced to singulate the IC dies on the wafer or panel. The singulated IC dies may then be incorporated into an IC package, circuit board, electronic device, system, etc.

At this point, the flowchart may be complete. In some embodiments, however, the flowchart may restart and/or certain blocks may be repeated. For example, in some embodiments, the flowchart may restart at block 802 to continue forming ICs with the same or similar design.

### Example Integrated Circuit Embodiments

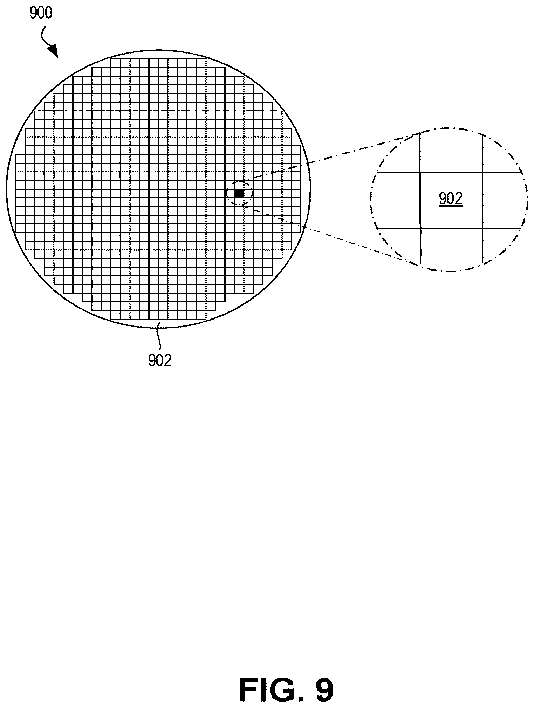

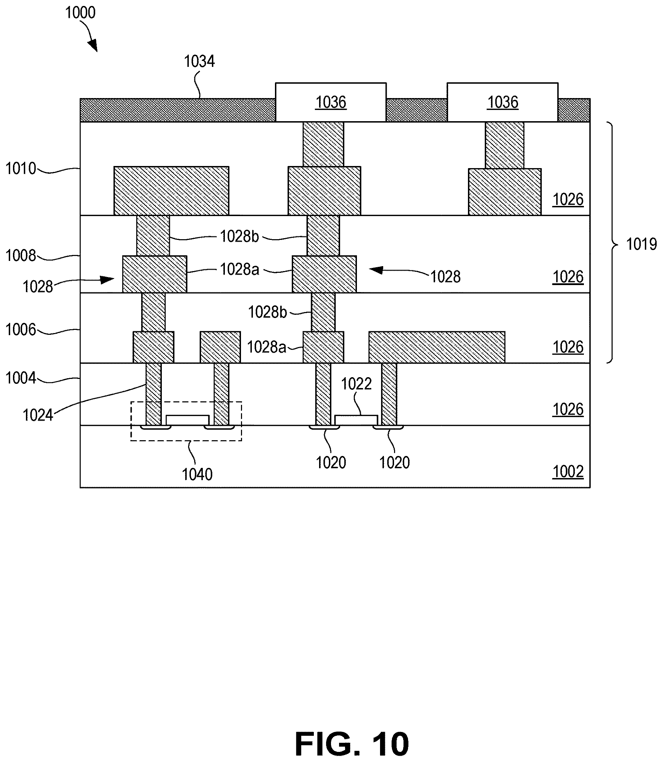

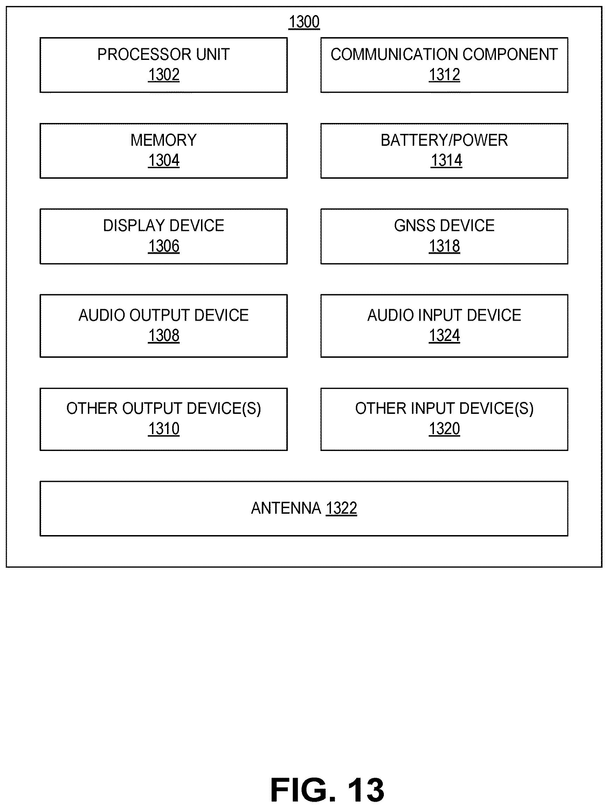

**FIG. 9** is a top view of a wafer 900 and dies 902 that may be included in, or may include, any of the embodiments disclosed herein. In some embodiments, for example, the dies 902 may include one or more semiconductor devices or transistors according to any of the embodiments disclosed herein (e.g., device 100, diode 101, transistor 103, IC 700). The wafer 900 may be composed of semiconductor material and may include one or more dies 902 having integrated circuit structures formed on a surface of the wafer 900. The individual dies 902 may be a repeating unit of an integrated circuit product that includes any suitable integrated circuit. After the fabrication of the semiconductor product is complete, the wafer 900 may undergo a singulation process in which the dies 902 are separated from one another to provide discrete "chips" of the integrated circuit product. The die 902 may be any of the dies disclosed herein. The die 902 may include one or more transistors (e.g., some of the transistors 1040 of FIG. 10, discussed below), supporting circuitry to route electrical signals to the transistors, passive components (e.g., signal traces, resistors, capacitors, or inductors), and/or any other integrated circuit components. In some embodiments, the wafer 900 or the die 902 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 902. For example, a memory array formed by multiple memory devices may be formed on a same die 902 as a processor unit (e.g., the processor unit 1302 of FIG. 13) or other logic that is configured to store information in the memory devices or execute instructions stored in the memory array. Various ones of the microelectronic assemblies disclosed herein may be manufactured using a die-to-wafer assembly technique in which some dies are attached to a wafer 900 that include others of the dies, and the wafer 900 is subsequently singulated.

**FIG. 10** is a cross-sectional side view of an integrated circuit device 1000 that may include, or may be included in, any of the embodiments disclosed herein (e.g., device 100, diode 101, transistor 103, IC 700). One or more of the integrated circuit devices 1000 may be included in one or more dies 902 (FIG. 9). The integrated circuit device 1000 may be formed on a die substrate 1002 (e.g., the wafer 900 of FIG. 9) and may be included in a die (e.g., the die 902 of FIG. 9). The die substrate 1002 may be a semiconductor substrate composed of semiconductor material systems including, for example, n-type or p-type materials systems (or a combination of both). The die substrate 1002 may include, for example, a crystalline substrate formed using a bulk silicon or a silicon-on-insulator (SOI) substructure. In some embodiments, the die substrate 1002 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1002. Although a few examples of materials from which the die substrate 1002 may be formed are described here, any material that may serve as a foundation for an integrated circuit device 1000 may be used. The die substrate 1002 may be part of a singulated die (e.g., the dies 902 of FIG. 9) or a wafer (e.g., the wafer 900 of FIG. 9).

The integrated circuit device 1000 may include one or more device layers 1004 disposed on the die substrate 1002. The device layer 1004 may include features of one or more transistors 1040 (e.g., metal oxide semiconductor field-effect transistors (MOSFETs)) formed on the die substrate 1002. The transistors 1040 may include, for example, one or more source and/or drain (S/D) regions 1020, a gate 1022 to control current flow between the S/D regions 1020, and one or more S/D contacts 1024 to route electrical signals to/from the S/D regions 1020. The transistors 1040 may include additional features not depicted for the sake of clarity, such as device isolation regions, gate contacts, and the like. The transistors 1040 are not limited to the type and configuration depicted in FIG. 10 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon, nanosheet, or nanowire transistors.

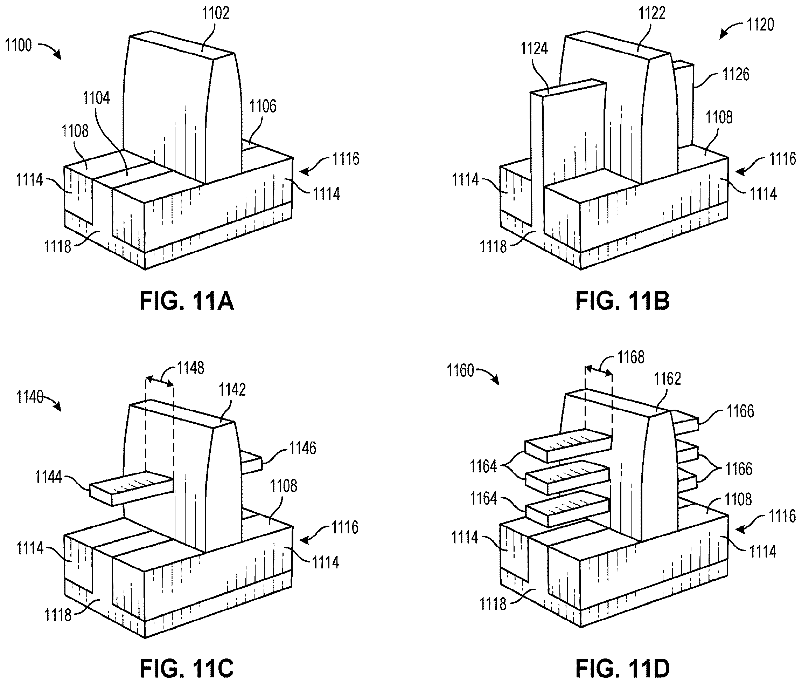

**FIGS. 11A-D** are simplified perspective views of example planar, FinFET, gate-all-around, and stacked gate-all-around transistors. In some embodiments, these transistors may be implemented according to any of the embodiments disclosed here in (e.g., device 100, transistor 103, IC 700). The transistors illustrated in FIGS. 11A-11D are formed on a substrate 1116 having a surface 1108. Isolation regions 1114 separate the source and drain regions of the transistors from other transistors and from a bulk region 1118 of the substrate 1116.

FIG. 11A is a perspective view of an example planar transistor 1100 comprising a gate 1102 that controls current flow between a source region 1104 and a drain region 1106. The transistor 1100 is planar in that the source region 1104 and the drain region 1106 are planar with respect to the substrate surface 1108.

FIG. 11B is a perspective view of an example FinFET transistor 1120 comprising a gate 1122 that controls current flow between a source region 1124 and a drain region 1126. The transistor 1120 is non-planar in that the source region 1124 and the drain region 1126 comprise "fins" that extend upwards from the substrate surface 1118. As the gate 1122 encompasses three sides of the semiconductor fin that extends from the source region 1124 to the drain region 1126, the transistor 1120 can be considered a tri-gate transistor. FIG. 11B illustrates one S/D fin extending through the gate 1122, but multiple S/D fins can extend through the gate of a FinFET transistor.

FIG. 11C is a perspective view of a gate-all-around (GAA) transistor 1140 comprising a gate 1142 that controls current flow between a source region 1144 and a drain region 1146. The transistor 1140 is non-planar in that the source region 1144 and the drain region 1146 are elevated from the substrate surface 1128.

FIG. 11D is a perspective view of a GAA transistor 1160 comprising a gate 1162 that controls current flow between multiple elevated source regions 1164 and multiple elevated drain regions 1166. The transistor 1160 is a stacked GAA transistor as the gate controls the flow of current between multiple elevated S/D regions stacked on top of each other. The transistors 1140 and 1160 are considered gate-all-around transistors as the gates encompass all sides of the semiconductor portions that extends from the source regions to the drain regions. The transistors 1140 and 1160 can alternatively be referred to as nanowire, nanosheet, or nanoribbon transistors depending on the width (e.g., widths 1148 and 1168 of transistors 1140 and 1160, respectively) of the semiconductor portions extending through the gate.

Returning to FIG. 10, a transistor 1040 may include a gate 1022 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1040 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1040 along the source-channel-drain direction, the gate electrode may consist of a U-shaped structure that includes a bottom portion substantially parallel to the surface of the die substrate 1002 and two sidewall portions that are substantially perpendicular to the top surface of the die substrate 1002. In other embodiments, at least one of the metal layers that form the gate electrode may simply be a planar layer that is substantially parallel to the top surface of the die substrate 1002 and does not include sidewall portions substantially perpendicular to the top surface of the die substrate 1002. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1020 may be formed within the die substrate 1002 adjacent to the gate 1022 of individual transistors 1040. The S/D regions 1020 may be formed using an implantation/diffusion process or an etching/deposition process, for example. In the former process, dopants such as boron, aluminum, antimony, phosphorous, or arsenic may be ionimplanted into the die substrate 1002 to form the S/D regions 1020. An annealing process that activates the dopants and causes them to diffuse farther into the die substrate 1002 may follow the ion-implantation process. In the latter process, the die substrate 1002 may first be etched to form recesses at the locations of the S/D regions 1020. An epitaxial deposition process may then be carried out to fill the recesses with material that is used to fabricate the S/D regions 1020. In some implementations, the S/D regions 1020 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1020 may be formed using one or more alternate semiconductor materials such as germanium or a group III-V material or alloy. In further embodiments, one or more layers of metal and/or metal alloys may be used to form the S/D regions 1020.

Electrical signals, such as power and/or input/output (I/O) signals, may be routed to and/or from the devices (e.g., transistors 1040) of the device layer 1004 through one or more interconnect layers disposed on the device layer 1004 (illustrated in FIG. 10 as interconnect layers 1006-1010). For example, electrically conductive features of the device layer 1004 (e.g., the gate 1022 and the S/D contacts 1024) may be electrically coupled with the interconnect structures 1028 of the interconnect layers 1006-1010. The one or more interconnect layers 1006-1010 may form a metallization stack (also referred to as an "ILD stack") 1019 of the integrated circuit device 1000.

The interconnect structures 1028 may be arranged within the interconnect layers 1006-1010 to route electrical signals according to a wide variety of designs; in particular, the arrangement is not limited to the particular configuration of interconnect structures 1028 depicted in FIG. 10. Although a particular number of interconnect layers 1006-1010 is depicted in FIG. 10, embodiments of the present disclosure include integrated circuit devices having more or fewer interconnect layers than depicted.

In some embodiments, the interconnect structures 1028 may include lines 1028a and/or vias 1028b filled with an electrically conductive material such as a metal. The lines 1028a may be arranged to route electrical signals in a direction of a plane that is substantially parallel with a surface of the die substrate 1002 upon which the device layer 1004 is formed. For example, the lines 1028a may route electrical signals in a direction in and out of the page and/or in a direction across the page from the perspective of FIG. 10. The vias 1028b may be arranged to route electrical signals in a direction of a plane that is substantially perpendicular to the surface of the die substrate 1002 upon which the device layer 1004 is formed. In some embodiments, the vias 1028b may electrically couple lines 1028a of different interconnect layers 1006-1010 together.

The interconnect layers 1006-1010 may include a dielectric material 1026 disposed between the interconnect structures 1028, as shown in FIG. 10. In some embodiments, dielectric material 1026 disposed between the interconnect structures 1028 in different ones of the interconnect layers 1006-1010 may have different compositions; in other embodiments, the composition of the dielectric material 1026 between different interconnect layers 1006-1010 may be the same. The device layer 1004 may include a dielectric material 1026 disposed between the transistors 1040 and a bottom layer of the metallization stack as well. The dielectric material 1026 included in the device layer 1004 may have a different composition than the dielectric material 1026 included in the interconnect layers 1006-1010; in other embodiments, the composition of the dielectric material 1026 in the device layer 1004 may be the same as a dielectric material 1026 included in any one of the interconnect layers 1006-1010.

A first interconnect layer 1006 (referred to as Metal 1 or "M1") may be formed directly on the device layer 1004. In some embodiments, the first interconnect layer 1006 may include lines 1028a and/or vias 1028b, as shown. The lines 1028a of the first interconnect layer 1006 may be coupled with contacts (e.g., the S/D contacts 1024) of the device layer 1004. The vias 1028b of the first interconnect layer 1006 may be coupled with the lines 1028a of a second interconnect layer 1008.

The second interconnect layer 1008 (referred to as Metal 2 or "M2") may be formed directly on the first interconnect layer 1006. In some embodiments, the second interconnect layer 1008 may include via 1028b to couple the lines 1028 of the second interconnect layer 1008 with the lines 1028a of a third interconnect layer 1010. Although the lines 1028a and the vias 1028b are structurally delineated with a line within individual interconnect layers for the sake of clarity, the lines 1028a and the vias 1028b may be structurally and/or materially contiguous (e.g., simultaneously filled during a dual-damascene process) in some embodiments.

The third interconnect layer 1010 (referred to as Metal 3 or "M3") (and additional interconnect layers, as desired) may be formed in succession on the second interconnect layer 1008 according to similar techniques and configurations described in connection with the second interconnect layer 1008 or the first interconnect layer 1006. In some embodiments, the interconnect layers that are "higher up" in the metallization stack 1019 in the integrated circuit device 1000 (i.e., farther away from the device layer 1004) may be thicker that the interconnect layers that are lower in the metallization stack 1019, with lines 1028a and vias 1028b in the higher interconnect layers being thicker than those in the lower interconnect layers.

The integrated circuit device 1000 may include a solder resist material 1034 (e.g., polyimide or similar material) and one or more conductive contacts 1036 formed on the interconnect layers 1006-1010. In FIG. 10, the conductive contacts 1036 are illustrated as taking the form of bond pads. The conductive contacts 1036 may be electrically coupled with the interconnect structures 1028 and configured to route the electrical signals of the transistor(s) 1040 to external devices. For example, solder bonds may be formed on the one or more conductive contacts 1036 to mechanically and/or electrically couple an integrated circuit die including the integrated circuit device 1000 with another component (e.g., a printed circuit board). The integrated circuit device 1000 may include additional or alternate structures to route the electrical signals from the interconnect layers 1006-1010; for example, the conductive contacts 1036 may include other analogous features (e.g., posts) that route the electrical signals to external components. The conductive contacts 1036 may serve as any of the conductive contacts described throughout this disclosure.

In some embodiments in which the integrated circuit device 1000 is a double-sided die, the integrated circuit device 1000 may include another metallization stack (not shown) on the opposite side of the device layer(s) 1004. This metallization stack may include multiple interconnect layers as discussed above with reference to the interconnect layers 1006-1010, to provide conductive pathways (e.g., including conductive lines and vias) between the device layer(s) 1004 and additional conductive contacts (not shown) on the opposite side of the integrated circuit device 1000 from the conductive contacts 1036. These additional conductive contacts may serve as any of the conductive contacts described throughout this disclosure.

In other embodiments in which the integrated circuit device 1000 is a double-sided die, the integrated circuit device 1000 may include one or more through silicon vias (TSVs) through the die substrate 1002; these TSVs may make contact with the device layer(s) 1004, and may provide conductive pathways between the device layer(s) 1004 and additional conductive contacts (not shown) on the opposite side of the integrated circuit device 1000 from the conductive contacts 1036. These additional conductive contacts may serve as any of the conductive contacts described throughout this disclosure. In some embodiments, TSVs extending through the substrate can be used for routing power and ground signals from conductive contacts on the opposite side of the integrated circuit device 1000 from the conductive contacts 1036 to the transistors 1040 and any other components integrated into the die 1000, and the metallization stack 1019 can be used to route I/O signals from the conductive contacts 1036 to transistors 1040 and any other components integrated into the die 1000.

Multiple integrated circuit devices 1000 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

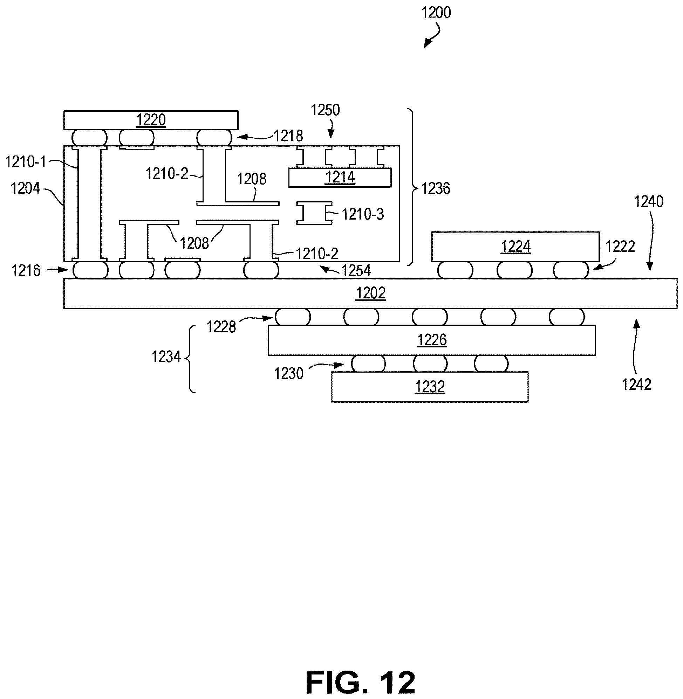

**FIG. 12** is a cross-sectional side view of an integrated circuit device assembly 1200 that may include any of the embodiments disclosed herein. In some embodiments, for example, the embedded devices 1214 and/or IC components 1220, 1224, 1226, 1232 of the integrated circuit device assembly 1200 may include one or more semiconductor devices (e.g., diodes, transistors) according to any of the embodiments disclosed herein (e.g., device 100, diode 101, transistor 103, IC 700). In some embodiments, the integrated circuit device assembly 1200 may be a microelectronic assembly. The integrated circuit device assembly 1200 includes a number of components disposed on a circuit board 1202 (which may be a motherboard, system board, mainboard, etc.). The integrated circuit device assembly 1200 includes components disposed on a first face 1240 of the circuit board 1202 and an opposing second face 1242 of the circuit board 1202; generally, components may be disposed on one or both faces 1240 and 1242. Any of the integrated circuit components discussed below with reference to the integrated circuit device assembly 1200 may take the form of any suitable ones of the embodiments of the microelectronic assemblies disclosed herein.

In some embodiments, the circuit board 1202 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1202. In other embodiments, the circuit board 1202 may be a non-PCB substrate. The integrated circuit device assembly 1200 illustrated in FIG. 12 includes a package-on-interposer structure 1236 coupled to the first face 1240 of the circuit board 1202 by coupling components 1216. The coupling components 1216 may electrically and mechanically couple the package-on-interposer structure 1236 to the circuit board 1202, and may include solder balls (as shown in FIG. 12), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. The coupling components 1216 may serve as the coupling components illustrated or described for any of the substrate assembly or substrate assembly components described herein, as appropriate.

The package-on-interposer structure 1236 may include an integrated circuit component 1220 coupled to an interposer 1204 by coupling components 1218. The coupling components 1218 may take any suitable form for the application, such as the forms discussed above with reference to the coupling components 1216. Although a single integrated circuit component 1220 is shown in FIG. 12, multiple integrated circuit components may be coupled to the interposer 1204; indeed, additional interposers may be coupled to the interposer 1204. The interposer 1204 may provide an intervening substrate used to bridge the circuit board 1202 and the integrated circuit component 1220.

The integrated circuit component 1220 may be a packaged or unpackaged integrated circuit product that includes one or more integrated circuit dies (e.g., the die 902 of FIG. 9, the integrated circuit device 1000 of FIG. 10) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 1220, a single monolithic integrated circuit die comprises solder bumps attached to contacts on the die. The solder bumps allow the die to be directly attached to the interposer 1204. The integrated circuit component 1220 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1220 can comprise one or more additional active or passive devices such as capacitors, decoupling capacitors, resistors, inductors, fuses, diodes, transformers, sensors, electrostatic discharge (ESD) devices, and memory devices,

In embodiments where the integrated circuit component 1220 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1220 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1204 may spread connections to a wider pitch or reroute a connection to a different connection. For example, the interposer 1204 may couple the integrated circuit component 1220 to a set of ball grid array (BGA) conductive contacts of the coupling components 1216 for coupling to the circuit board 1202. In the embodiment illustrated in FIG. 12, the integrated circuit component 1220 and the circuit board 1202 are attached to opposing sides of the interposer 1204; in other embodiments, the integrated circuit component 1220 and the circuit board 1202 may be attached to a same side of the interposer 1204. In some embodiments, three or more components may be interconnected by way of the interposer 1204.

In some embodiments, the interposer 1204 may be formed as a PCB, including multiple metal layers separated from one another by layers of dielectric material and interconnected by electrically conductive vias. In some embodiments, the interposer 1204 may be formed of an epoxy resin, a fiberglass-reinforced epoxy resin, an epoxy resin with inorganic fillers, a ceramic material, or a polymer material such as polyimide. In some embodiments, the interposer 1204 may be formed of alternate rigid or flexible materials that may include the same materials described above for use in a semiconductor substrate, such as silicon, germanium, and other group III-V and group IV materials. The interposer 1204 may include metal interconnects 1208 and vias 1210, including but not limited to through hole vias 1210-1 (that extend from a first face 1250 of the interposer 1204 to a second face 1254 of the interposer 1204), blind vias 1210-2 (that extend from the first or second faces 1250 or 1254 of the interposer 1204 to an internal metal layer), and buried vias 1210-3 (that connect internal metal layers).

In some embodiments, the interposer 1204 can comprise a silicon interposer. Through silicon vias (TSV) extending through the silicon interposer can connect connections on a first face of a silicon interposer to an opposing second face of the silicon interposer. In some embodiments, an interposer 1204 comprising a silicon interposer can further comprise one or more routing layers to route connections on a first face of the interposer 1204 to an opposing second face of the interposer 1204.

The interposer 1204 may further include embedded devices 1214, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1204. The package-on-interposer structure 1236 may take the form of any of the package-on-interposer structures known in the art. In embodiments where the interposer is a non-printed circuit board

The integrated circuit device assembly 1200 may include an integrated circuit component 1224 coupled to the first face 1240 of the circuit board 1202 by coupling components 1222. The coupling components 1222 may take the form of any of the embodiments discussed above with reference to the coupling components 1216, and the integrated circuit component 1224 may take the form of any of the embodiments discussed above with reference to the integrated circuit component 1220.

The integrated circuit device assembly 1200 illustrated in FIG. 12 includes a package-on-package structure 1234 coupled to the second face 1242 of the circuit board 1202 by coupling components 1228. The package-on-package structure 1234 may include an integrated circuit component 1226 and an integrated circuit component 1232 coupled together by coupling components 1230 such that the integrated circuit component 1226 is disposed between the circuit board 1202 and the integrated circuit component 1232. The coupling components 1228 and 1230 may take the form of any of the embodiments of the coupling components 1216 discussed above, and the integrated circuit components 1226 and 1232 may take the form of any of the embodiments of the integrated circuit component 1220 discussed above. The package-on-package structure 1234 may be configured in accordance with any of the package-on-package structures known in the art.

**FIG. 13** is a block diagram of an example electrical device 1300 that may include one or more of the embodiments disclosed herein. For example, any suitable ones of the components of the electrical device 1300 may include one or more of the semiconductor devices (e.g., device 100, diode 101, transistor 103, IC 700), integrated circuit device assemblies 1200, integrated circuit components 1220, integrated circuit devices 1000, or integrated circuit dies 902 disclosed herein. A number of components are illustrated in FIG. 13 as included in the electrical device 1300, but any one or more of these components may be omitted or duplicated, as suitable for the application. In some embodiments, some or all of the components included in the electrical device 1300 may be attached to one or more motherboards mainboards, or system boards. In some embodiments, one or more of these components are fabricated onto a single system-on-a-chip (SoC) die.

Additionally, in various embodiments, the electrical device 1300 may not include one or more of the components illustrated in FIG. 13, but the electrical device 1300 may include interface circuitry for coupling to the one or more components. For example, the electrical device 1300 may not include a display device 1306, but may include display device interface circuitry (e.g., a connector and driver circuitry) to which a display device 1306 may be coupled. In another set of examples, the electrical device 1300 may not include an audio input device 1324 or an audio output device 1308, but may include audio input or output device interface circuitry (e.g., connectors and supporting circuitry) to which an audio input device 1324 or audio output device 1308 may be coupled.

The electrical device 1300 may include one or more processor units 1302 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1302 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1300 may include a memory 1304, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1304 may include memory that is located on the same integrated circuit die as the processor unit 1302. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1300 can comprise one or more processor units 1302 that are heterogeneous or asymmetric to another processor unit 1302 in the electrical device 1300. There can be a variety of differences between the processing units 1302 in a system in terms of a spectrum of metrics of merit including architectural, microarchitectural, thermal, power consumption characteristics, and the like. These differences can effectively manifest themselves as asymmetry and heterogeneity among the processor units 1302 in the electrical device 1300.

In some embodiments, the electrical device 1300 may include a communication component 1312 (e.g., one or more communication components). For example, the communication component 1312 can manage wireless communications for the transfer of data to and from the electrical device 1300. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1312 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1312 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1312 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1312 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1312 may operate in accordance with other wireless protocols in other embodiments. The electrical device 1300 may include an antenna 1322 to facilitate wireless communications and/or to receive other wireless communications (such as AM or FM radio transmissions).

In some embodiments, the communication component 1312 may manage wired communications, such as electrical, optical, or any other suitable communication protocols (e.g., IEEE 802.3 Ethernet standards). As noted above, the communication component 1312 may include multiple communication components. For instance, a first communication component 1312 may be dedicated to shorter-range wireless communications such as Wi-Fi or Bluetooth, and a second communication component 1312 may be dedicated to longer-range wireless communications such as global positioning system (GPS), EDGE, GPRS, CDMA, WiMAX, LTE, EV-DO, or others. In some embodiments, a first communication component 1312 may be dedicated to wireless communications, and a second communication component 1312 may be dedicated to wired communications.

The electrical device 1300 may include battery/power circuitry 1314. The battery/power circuitry 1314 may include one or more energy storage devices (e.g., batteries or capacitors) and/or circuitry for coupling components of the electrical device 1300 to an energy source separate from the electrical device 1300 (e.g., AC line power).

The electrical device 1300 may include a display device 1306 (or corresponding interface circuitry, as discussed above). The display device 1306 may include one or more embedded or wired or wirelessly connected external visual indicators, such as a heads-up display, a computer monitor, a projector, a touchscreen display, a liquid crystal display (LCD), a lightemitting diode display, or a flat panel display.

The electrical device 1300 may include an audio output device 1308 (or corresponding interface circuitry, as discussed above). The audio output device 1308 may include any embedded or wired or wirelessly connected external device that generates an audible indicator, such speakers, headsets, or earbuds.

The electrical device 1300 may include an audio input device 1324 (or corresponding interface circuitry, as discussed above). The audio input device 1324 may include any embedded or wired or wirelessly connected device that generates a signal representative of a sound, such as microphones, microphone arrays, or digital instruments (e.g., instruments having a musical instrument digital interface (MIDI) output). The electrical device 1300 may include a Global Navigation Satellite System (GNSS) device 1318 (or corresponding interface circuitry, as discussed above), such as a Global Positioning System (GPS) device. The GNSS device 1318 may be in communication with a satellite-based system and may determine a geolocation of the electrical device 1300 based on information received from one or more GNSS satellites, as known in the art.

The electrical device 1300 may include other output device(s) 1310 (or corresponding interface circuitry, as discussed above). Examples of the other output device(s) 1310 may include an audio codec, a video codec, a printer, a wired or wireless transmitter for providing information to other devices, or an additional storage device.

The electrical device 1300 may include other input device(s) 1320 (or corresponding interface circuitry, as discussed above). Examples of the other input device(s) 1320 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1300 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a display device (e.g., monitor, television), a set-top box, an entertainment control unit, a video game console, a video playback device, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1300 may be any other electronic device that processes data. In some embodiments, the electrical device 1300 may comprise multiple discrete physical components. Given the range of devices that the electrical device 1300 can be manifested as in various embodiments, in some embodiments, the electrical device 1300 can be referred to as a computing device or a computing system.

While the concepts of the present disclosure are susceptible to various modifications and alternative forms, specific embodiments thereof have been shown by way of example in the drawings and are described herein in detail. It should be understood, however, that there is no intent to limit the concepts of the present disclosure to the particular forms disclosed, but on the contrary, the intention is to cover all modifications, equivalents, and alternatives consistent with the present disclosure and the appended claims.

In the drawings, some structural or method features may be shown in specific arrangements and/or orderings. However, it should be appreciated that such specific arrangements and/or orderings may not be required. Rather, in some embodiments, such features may be arranged in a different manner and/or order than shown in the illustrative figures. Additionally, the inclusion of a structural or method feature in a particular figure is not meant to imply that such feature is required in all embodiments and, in some embodiments, may not be included or may be combined with other features. Further, it should be understood that the various embodiments shown in the figures are illustrative representations and are not necessarily drawn to scale.

Moreover, the illustrations and/or descriptions of various embodiments may be simplified or approximated for ease of understanding, and as a result, they may not necessarily reflect the level of precision nor variation that may be present in actual embodiments. For example, while some figures generally indicate straight lines, right angles, and smooth surfaces, actual implementations of the disclosed embodiments may have less than perfect straight lines and right angles, and some features may have surface topography or otherwise be non-smooth, given realworld limitations of fabrication processes. Similarly, illustrations and/or descriptions of how components are arranged may be simplified or approximated for ease of understanding and may vary by some margin of error in actual embodiments (e.g., due to fabrication processes, etc.).

The terms "substantially," "close," "approximately," "near," and "about" may refer to being within +/- 10% of a target value unless otherwise specified.

Similarly, terms describing spatial relationships, such as "perpendicular," "orthogonal," or "coplanar," may refer to being substantially within the described spatial relationships (e.g., within +/- 10 degrees of orthogonality).

Certain terminology may also be used in the foregoing description for the purpose of reference only, and thus are not intended to be limiting. For example, terms such as "upper," "lower," "above," "below," "bottom," and "top" refer to directions in the drawings to which reference is made. Terms such as "front," "back," "rear," and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

In some embodiments, the phrase "A is located on B" or the phrase "A is adjacent to B" means that at least a part of A is in direct physical contact or indirect physical contact (having one or more other features between A and B) with at least a part of B. Moreover, the phrase "B is between A and C" means that at least part of B is in or along a space separating A and C and that at least part of B is in direct or indirect physical contact with A and C.

The terms "coupled" and "connected" may refer to either a direct or indirect connection, such as a direct electrical, mechanical, or magnetic connection, or an indirect connection through one or more passive or active intermediary elements, components, or devices.

The phrases "in an embodiment," "according to some embodiments," "in accordance with embodiments," "in embodiments," and the like may each refer to one or more of the same or different embodiments.

The terms "comprises," "comprising," "includes," "including," "having" and the like specify the presence of the stated elements (e.g., features, components, materials, steps, operations) but do not preclude the presence or addition of one or more other elements.

The phrase "and/or" as used herein refers to and encompasses any and all possible combinations of one or more of the associated listed items.

The singular forms "a," "an," and "the" are intended to include the plural forms as well, unless the context clearly indicates otherwise. For example, plural instances may implement components, operations, or structures described as a single instance. Although individual operations of one or more methods are illustrated and described as separate operations, one or more of the individual operations may be performed concurrently, and nothing requires that the operations be performed in the order illustrated. Structures and functionality presented as separate components in example configurations may be implemented as a combined structure or component. Similarly, structures and functionality presented as a single component may be implemented as separate components. These and other variations, modifications, additions, and improvements fall within the scope of the subject matter herein.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

As used herein, "electrically conductive" in some examples may refer to a property of a material having an electrical conductivity greater than or equal to 10⁷ Siemens per meter (S/m) at 20 degrees Celsius. Examples of such materials include Cu, Ag, Al, Au, W, Zn, and Ni.

The terms "circuit" or "circuitry," as used in any embodiment herein may comprise, for example, singly or in any combination, hardwired circuitry, programmable circuitry such as computer processors comprising one or more individual instruction processing cores, state machine circuitry, and/or firmware that stores instructions executed by programmable circuitry. The circuitry may include a processor and/or controller configured to execute one or more instructions to perform one or more operations described herein. The instructions may be embodied as, for example, an application, software, firmware, etc. configured to cause the circuitry to perform any of the aforementioned operations. Software may be embodied as a software package, code, instructions, instruction sets and/or data recorded on a computer-readable storage device. Software may be embodied or implemented to include any number of processes, and processes, in turn, may be embodied or implemented to include any number of threads, etc., in a hierarchical fashion. Firmware may be embodied as code, instructions or instruction sets and/or data that are hard-coded (e.g., nonvolatile) in memory devices. The circuitry may, collectively or individually, be embodied as circuitry that forms part of a larger system, for example, an integrated circuit (IC), an application-specific integrated circuit (ASIC), a system-on-a-chip (SoC), desktop computers, laptop computers, tablet computers, servers, smart phones, etc. Other embodiments may be implemented as software executed by a programmable control device. In such cases, the terms "circuit" or "circuitry" are intended to include a combination of software and hardware such as a programmable control device or a processor capable of executing the software. As described herein, various embodiments may be implemented using hardware elements, software elements, or any combination thereof. Examples of hardware elements may include processors, microprocessors, circuits, circuit elements (e.g., transistors, resistors, capacitors, inductors, and so forth), integrated circuits, application specific integrated circuits (ASIC), programmable logic devices (PLD), digital signal processors (DSP), field programmable gate array (FPGA), logic gates, registers, semiconductor device, chips, microchips, chip sets, and so forth.

For purposes of some embodiments, the transistors in various circuits and logic blocks described herein may be metal oxide semiconductor (MOS) transistors or their derivatives, where the MOS transistors include drain, source, gate, and/or bulk terminals. The transistors and/or the MOS transistor derivatives also include Tri-Gate and FinFET transistors, Gate All Around Cylindrical Transistors, Tunneling FET (TFET), Square Wire, or Rectangular Ribbon Transistors, ferroelectric FET (FeFETs), or other devices implementing transistor functionality like carbon nanotubes or spintronic devices. MOSFET symmetrical source and drain terminals are identical terminals and may be used interchangeably herein. A TFET device, on the other hand, has asymmetric Source and Drain terminals. Those skilled in the art will appreciate that other transistors, for example, Bi-polar junction transistors--BJT PNP/NPN, BiCMOS, CMOS, eFET, etc., may be used without departing from the scope of the disclosure. The term "MN" indicates an n-type transistor (e.g., NMOS, NPN BJT, etc.) and the term "MP" indicates a p-type transistor (e.g., PMOS, PNP BJT, etc.). Moreover, in some embodiments, spintronic logic devices (e.g., magnetoelectric spin-orbit (MESO) logic devices) may be used in addition to, or as an alternative to, MOS transistors.

In the corresponding drawings of the embodiments, signals, currents, electrical biases, or magnetic or electrical polarities may be represented with lines. Some lines may be thicker, to indicate more constituent signal paths, and/or have arrows at one or more ends, to indicate primary information flow direction. Such indications are not intended to be limiting. Rather, the lines are used in connection with one or more exemplary embodiments to facilitate easier understanding of a circuit or a logical unit. Any represented signal, polarity, current, voltage, etc., as dictated by design needs or preferences, may actually comprise one or more signals that may travel in either direction and may be implemented with any suitable type of signal scheme.

In the foregoing description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, may not be described in detail in order to avoid unnecessarily obscuring embodiments of the present disclosure.

It is to be appreciated that the layers and materials described above are typically formed on or above an underlying semiconductor substrate or structure, such as underlying device layer(s) of an integrated circuit. In an embodiment, an underlying semiconductor substrate represents a general workpiece object used to manufacture integrated circuits. The semiconductor substrate often includes a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials. The semiconductor substrate, depending on the stage of manufacture, often includes transistors, integrated circuitry, and the like. The substrate may also include semiconductor materials, metals, dielectrics, dopants, and other materials commonly found in semiconductor substrates. Furthermore, the structures depicted above may be fabricated on underlying lower level back end of line (BEOL) interconnect layers.

Embodiments disclosed herein may be used to manufacture a wide variety of different types of integrated circuits and/or microelectronic devices. Examples of such integrated circuits include, but are not limited to, processors, chipset components, graphics processors, digital signal processors, microcontrollers, and the like. In other embodiments, semiconductor memory may be manufactured. Moreover, the integrated circuits or other microelectronic devices may be used in a wide variety of electronic devices known in the art. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

The disclosed embodiments may be implemented, in some cases, in hardware, firmware, software, or any combination thereof. The disclosed embodiments may also be implemented as instructions carried by or stored on one or more transitory or non-transitory machine-readable (e.g., computer-readable) storage media, which may be read and executed by one or more processors. A machine-readable storage medium may be embodied as any storage device, mechanism, or other physical structure for storing or transmitting information in a form readable by a machine, including volatile or non-volatile memory (e.g., random access memory (RAM), flash memory), hard drives (e.g., hard disk drive (HDD), solid state drive (SSD)), media discs, or combination thereof.

### Examples

Illustrative examples of the technologies described throughout this disclosure are provided below. Embodiments of these technologies may include any one or more, and any combination of, the examples described below. In some embodiments, at least one of the systems or components set forth in one or more of the preceding figures may be configured to perform one or more operations, techniques, processes, and/or methods as set forth in the following examples.

Example 1 includes a semiconductor device, comprising: a fin comprising silicon; a p-type epitaxial structure over the fin; an n-type epitaxial structure over the fin; and a dielectric liner under the fin, wherein the dielectric liner does not comprise oxygen.

Example 2 includes the semiconductor device of Example 1, wherein the dielectric liner comprises nitrogen.

Example 3 includes the semiconductor device of Example 1, wherein the dielectric liner comprises silicon and nitrogen.

Example 4 includes the semiconductor device of Example 1, wherein the dielectric liner comprises carbon.

Example 5 includes the semiconductor device of Example 1, wherein the dielectric liner comprises silicon and carbon.

Example 6 includes the semiconductor device of any one of Examples 1-5, wherein the dielectric liner has a thickness of 15 nanometers or less.

Example 7 includes the semiconductor device of any one of Examples 1-6, wherein the dielectric liner is a hermetic liner.

Example 8 includes the semiconductor device of any one of Examples 1-7, wherein: the p-type epitaxial structure comprises: silicon and boron; or silicon, germanium, and boron; and the n-type epitaxial structure comprises: silicon and phosphorus; or silicon and arsenic.

Example 9 includes the semiconductor device of any one of Examples 1-7, wherein: the p-type epitaxial structure comprises: silicon doped with boron; or silicon germanium doped with boron; and the n-type epitaxial structure comprises: silicon doped with phosphorus; or silicon doped with arsenic.

Example 10 includes the semiconductor device of any one of Examples 1-9, further comprising: a first conductive contact over the p-type epitaxial structure; and a second conductive contact over the n-type epitaxial structure.

Example 11 includes the semiconductor device of Example 10, wherein the first conductive contact is an anode, and wherein the second conductive contact is a cathode.

Example 12 includes the semiconductor device of any one of Examples 1-11, wherein the fin further comprises: a p-type region; an n-type region; or a p-type region and an n-type region.

Example 13 includes the semiconductor device of any one of Examples 1-12, wherein the fin is below one or more nanowires or one or more gates.

Example 14 includes the semiconductor device of any one of Examples 1-13, further comprising a diode, wherein the diode comprises the p-type epitaxial structure, the n-type epitaxial structure, and the fin.

Example 15 includes the semiconductor device of Example 14, further comprising: a first plurality of conductive layers above the diode; and a second plurality of conductive layers below the diode.

Example 16 includes the semiconductor device of any one of Examples 1-15, further comprising one or more vias lateral to the fin.

Example 17 includes the semiconductor device of Example 16, wherein the one or more vias comprise tungsten or molybdenum.

Example 18 includes an electronic device, comprising: one or more diodes, wherein the respective diodes comprise: a p-type epitaxial structure; an n-type epitaxial structure; a fin under the p-type epitaxial structure and the n-type epitaxial structure, wherein the p-type epitaxial structure and the n-type epitaxial structure are coupled via the fin, wherein the fin comprises a semiconductor; and a hermetic liner under the fin.

Example 19 includes the electronic device of Example 18, wherein the hermetic liner comprises nitrogen or carbon.

Example 20 includes the electronic device of Example 18, wherein the hermetic liner comprises silicon and nitrogen.

Example 21 includes the electronic device of Example 18, wherein the hermetic liner comprises silicon and carbon.

Example 22 includes the electronic device of any one of Examples 18-21, wherein the hermetic liner does not comprise oxygen.

Example 23 includes the electronic device of any one of Examples 18-22, wherein: the p-type epitaxial structure comprises: silicon doped with boron; or silicon germanium doped with boron; and the n-type epitaxial structure comprises: silicon doped with phosphorus; or silicon doped with arsenic.

Example 24 includes the electronic device of any one of Examples 18-23, further comprising: an anode coupled to the p-type epitaxial structure; and a cathode coupled to the n-type epitaxial structure.

Example 25 includes the electronic device of any one of Examples 18-24, further comprising one or more transistors, wherein the fin is below the one or more transistors.

Example 26 includes the electronic device of any one of Examples 18-25, further comprising: a first interconnect above the one or more diodes; and a second interconnect below the one or more diodes.

Example 27 includes the electronic device of Example 26, further comprising one or more vias lateral to the one or more diodes, wherein the first interconnect and the second interconnect are electrically coupled through the one or more vias.

Example 28 includes the electronic device of any one of Examples 18-27, further comprising: a circuit board; and an integrated circuit coupled to the circuit board, wherein the integrated circuit comprises processing circuitry, memory circuitry, storage circuitry, or communication circuitry, wherein one or more of the diodes are comprised in the processing circuitry, the memory circuitry, the storage circuitry, or the communication circuitry.

Example 29 includes a method, comprising: receiving a substrate; forming a plurality of fins over the substrate; forming a device layer over the fins, wherein the device layer comprises one or more diodes and one or more transistors; thinning a backside of the substrate; recessing a backside of the fins; forming a hermetic liner over the backside of the fins; and removing one or more fins under the one or more transistors, the one or more fins from the plurality of fins.

Example 30 includes the method of Example 29, wherein the hermetic liner comprises nitrogen or carbon.

Example 31 includes the method of any one of Examples 29-30, further comprising: forming a first interconnect above the device layer; and forming a second interconnect below the device layer.

Example 32 includes the method of Example 31, further comprising forming one or more vias lateral to the one or more diodes or the one or more transistors, wherein the first interconnect and the second interconnect are electrically coupled through the one or more vias.

Example 33 includes the method of any one of Examples 29-32, further comprising planarizing the backside of the substrate.

Example 34 includes a method of forming the semiconductor device of any one of Examples 1-17.

Example 35 includes a method of forming the electronic device of any one of Examples 18-28.

## Claims

1. A semiconductor device, comprising:
a fin comprising silicon;
a p-type epitaxial structure over the fin;
an n-type epitaxial structure over the fin; and
a dielectric liner under the fin, wherein the dielectric liner does not comprise oxygen.

2. The semiconductor device of Claim 1, wherein the dielectric liner comprises nitrogen.

3. The semiconductor device of Claim 1, wherein the dielectric liner comprises silicon and nitrogen.

4. The semiconductor device of Claim 1, wherein the dielectric liner comprises carbon.

5. The semiconductor device of Claim 1, wherein the dielectric liner comprises silicon and carbon.

6. The semiconductor device of any one of Claims 1-5, wherein the dielectric liner has a thickness of 15 nanometers or less.

7. The semiconductor device of any one of Claims 1-6, wherein the dielectric liner is a hermetic liner.

8. The semiconductor device of any one of Claims 1-7, wherein:
the p-type epitaxial structure comprises:
silicon and boron; or
silicon, germanium, and boron; and
the n-type epitaxial structure comprises:
silicon and phosphorus; or
silicon and arsenic.

9. The semiconductor device of any one of Claims 1-8, further comprising:
a first conductive contact over the p-type epitaxial structure; and
a second conductive contact over the n-type epitaxial structure.

10. The semiconductor device of any one of Claims 1-9, wherein the fin further comprises:
a p-type region;
an n-type region; or
a p-type region and an n-type region.

11. The semiconductor device of any one of Claims 1-10, wherein the fin is below one or more nanowires or one or more gates.

12. The semiconductor device of any one of Claims 1-11, further comprising a diode, wherein the diode comprises the p-type epitaxial structure, the n-type epitaxial structure, and the fin.

13. The semiconductor device of any one of Claims 1-12, further comprising one or more vias lateral to the fin.

14. A method of forming the semiconductor device of any one of Claims 1-13.

15. At least one machine-accessible storage medium having instructions stored thereon, wherein the instructions, when executed on a machine, cause the machine to perform a method or realize an apparatus as claimed in any preceding claim.
